# EUROPÄISCHE PATENTANMELDUNG

(11) **EP 1 879 239 A2**
(43) Veröffentlichungstag der Anmeldung: **16.01.2008**
(21) Anmeldenummer: 07013685.8
(22) Anmeldetag: 12.07.2007
(51) Int. Cl.: H01L 35/32

(54) **Thermoelektrisches Element**

(30) Priorität: 13.07.2006 DE 102006032654
(71) Anmelder: EES GmbH, 06846 Dessau (DE)
(72) Erfinder: Heinz, Gerhard, 06386 Scheuder (DE)
(74) Vertreter: Tragsdorf, Bodo

(57) **Zusammenfassung**

Die Erfindung bezieht sich auf ein thermoelektrisches Element, Insbesondere zur Erzeugung von elektrischer Energie, wobei eine Temperaturdifferenz an ein thermoelektrisches Element angelegt wird.

Ausgehend von den Nachteilen des bekannten Standes der Technik soll ein thermoelektrisches Element, Insbesondere zur Erzeugung von elektrischer Energie, geschaffen werden, das sich durch einen verbesserten Wirkungsgrad auszeichnet.

Als Lösung wird hierzu vorgeschlagen, dass zwischen den an sich üblichen Elementen 3,4 aus Metall oder Haibleltern eine Funktionsschicht 5 angeordnet ist, die aus einer Matrix aus zwei Komponenten besteht. Die erste Komponente ist ein Wärme reflektierendes Isolationsmaterial. Die zweite Komponente besteht entweder aus einem Material auf Basis Kohlenstoff-Nano-Röhrchen oder einem Vorprodukt aus der Herstellung dieser Röhrchen, als mehratomige Kohlenstoff-Halbkugelstruktur. Das Isolationsmaterial und das Kohlenstoff-Nano-Röhrchen-Material bzw. dessen Vorprodukt befinden sich in unmittelbarem Kontakt mit beiden Metallen oder Halbleitern 3, 4, wobei die elektrische Kopplung zwischen den beiden leitenden Elementen 3, 4 über die zweite Komponente 5a, die Kohlenstoff-Nano-Röhrchen oder deren Vorprodukt erfolgt.

Durch die Anordnung dieser speziellen Funktionsschicht wird ein deutlich verbesserter Wirkungsgrad des thermoelektrischen Elementes erreicht.

Die erfindungsgemäßen thermoelektrischen Elemente können außer zur Stromerzeugung, insbesondere von Solarkollektoren, auch zur Erzeugung von Kälte oder wärmeenergie eingesetzt werden, In analoger Weise wie dies von Peltierelementen bekannt Ist.

## Beschreibung

Die Erfindung bezieht sich auf ein thermoelektrisches Element, Insbesondere zur Erzeugung von elektrischer Energie, wobei eine Temperaturdifferenz an ein thermoelektrisches Element angelegt wird.

Thermoelektrische Elemente zur Erzeugung von Strom sind bereits seit langem bekannt. Diese werden z.B. zur Umwandlung von Solarenergie in elektrische Energie eingesetzt. Die Umwandlung beruht auf dem bekannten Seebeck-Effekt. Bei Kontakt von zwei unterschiedlichen Metallen oder Halbleitern wird in der Berührungsschicht aufgrund der unterschiedllchen Austrittsarbeit der Elektronen eine temperaturabhängige Kontaktspannung erzeugt. Werden die Enden von zwei unterschiedlichen Metallen oder Halbleitern miteinander verbunden und die Verbindungsstellen unterschiedlichen Temperaturen ausgesetzt, so entsteht eine Thermospannung und im Leiterstromkreis fließt ein Thermostrom. Der Leiterkreis bildet ein Thermoelement. Die erzeugte Thermospannung ist abhängig von der Temperaturdifferenz zwischen den Verbindungsstellen und nimmt mit steigender Temperaturdifferenz zu. Außerdem ist diese abhängig von den verwendeten Metall- bzw. Halbleiterkombinationen.

Aus der DE 195 19 978 A1 ist es bekannt, einen Sonnekollektor zur Erwärmung eines Mediums mit Thermogeneratoren zur Erzeugung von Strom auszurüsten. Diese sind zwischen dem die Wärme umwandelnden Absorber und dem die Wärme abführenden Medium angeordnet. Zur Verbesserung des Wirkungsgrades wird der Sonnenkollektor innerhalb eines evakulerbaren Gehäuses untergebracht.

Als Thermogeneratoren sind auch Peltierelemente bekannt, die aus zwei Halbleiterschenkeln bestehen, von denen der eine n-leitend und der andere p-leitend ist. Ober eine Kupferbrücke sind die beiden Schenkel an ihrer Stirnseite verbunden. Wenn zwischen der warmen und der kalten Seite eines Peltierelementes eine Temperaturdifferenz aufgebaut wird, so weisen die Anschlusspunkte eine elektrische Spannung auf, deren Höhe u.a. von der Temperaturdifferenz abhängig ist.

Die thermoelektrische Elemente besitzen nur einen geringen Wirkungsgrad. Dieser beträgt z.B. bei einer Temperaturdifferenz von 6°K 2%.

Der Erfindung liegt die Aufgabe zugrunde, ein thermoelektrisches Element, insbesondere zur Erzeugung von elektrischer Energie, zu schaffen, das sich durch einen verbesserten Wirkungsgrad auszeichnet.

Erfindungsgemäß wird die Aufgabe durch die im Anspruch 1 angegebenen Merkmale gelöst. Vorteilhafte Ausgestaltungen und Weiterbildungen sind Gegenstand der Ansprüche 2 bis 8.

Das vorgeschlagene thermoelektrische Element besitzt zwischen den an sich üblichen Elementen aus Metall oder Halbleitern eine Funktionsschicht, die aus einer Matrix aus zwei Komponenten besteht. Die erste Komponente Ist ein Wärme reflektierendes Isolationsmaterial. Die zweite Komponente besteht entweder aus einem Material auf Basis Kohlenstoff-Nano-Röhrchen oder einem Vorprodukt aus der Herstellung dieser Röhrchen, als mehratomige Kohlenstoff-Halbkugelstruktur. Es handelt sich dabei um Fullerene, die bei der Generierung von Kohlenstoff automatisch gebildet werden und die kleinste Struktur in Form einer Halbkugel bilden. Dieses Vorprodukt hat im Wesentlichen die gleichen Eigenschaften wie Kohlenstoff-Nano-Röhrchen.

Das isolationsmaterial und das Kohlenstoff-Nano-Röhrchen-Material bzw. das Vorprodukt befinden sich in unmittelbarem Kontakt mit beiden Metallen oder Halbleitern, wobei die elektrische Kopplung zwischen den beiden leitenden Elementen (Metall oder Halbleiter) über die zweite Komponente, die Kohlenstoff-Nano-Röhrchen oder deren Vorprodukt erfolgt.

Durch die Anordnung dieser speziellen Funktionsschicht wird ein deutlich verbesserter Wirkungsgrad des thermoelektrischen Elementes erreicht. Die Kohlenstoff-Nano-Röhrchen besitzen eine sehr hohe Stromleitfähigkeit, wobei die Elektronen nahezu ohne oder mit geringem Widerstand fließen und ein sogenannter Tunneleffekt eintritt. An der Außenseite der Kohlenstoff-Nano-Röhrchen wird ein Magnetfeld erzeugt, das die Konzentration des Elektronenstroms begünstigt. Gleichzeitig bildet die Isolationsschicht durch Reflexion ein Temperaturschild.

Durch die Kohlenstoff-Nano-Röhrchen wird eine hohe Stromdichte und Konzentration der Feldstärke erreicht. Aufgrund des hohen Wärmereflexionsvermögens des Isollenmaterials und sehr guten Leitfähigkeit der Kohlenstoff-Nano-Röhrchen wird eine optimale Wärmerückstrahlung bewirkt, sodass eine hohe Temperaturdifferenz problemlos gehalten werden kann. Der Wärmefluss erfolgt Im Wesentlichen über den Elektronenstrom.

Als Metall- oder Halbleiter für die flächenförmigen Elemente können die an sich bekannten Werkstoffe, wie Kupfer, Aluminium oder Antimon-Verbindungen, eingesetzt werden.

Die Metalle oder Halbleiter sind in einem parallelen Abstand von 1 bis 1000 Nanometer, vorzugsweise 10 bis 500 Nanometer, angeordnet. Die zwischen diesen befindlichen Abschnitte aus Isolationsmaterial und dem Material der Kohlenstoff-Nana-Röhrehen sind abwechselnd angeordnet. Die gebildete Funktionsschicht besitzt eine Dicke, die innerhalb des vorgenannten Nanometerbereiches liegt. Die Kohienstoff-Nano-Röhrchen besitzen vorzugsweise einen nahezu einheitlichen Durchmesser, im Bereich von 1 bis 100 Nanometer, und können in einem rechten Winkel oder in einem leicht geneigten Winkel, von bis zu 10°, zu den Elementen aus Metall oder Halbleiter angeordnet sein. Es kann auch ein Kohlenstoff-Nano.

Röhrchen-Material eingesetzt werden, bei dem die einzelnen Röhrchen unterschiedliche Durchmesser aufweisen.

Als Wärme reflektierendes Isolationematerial sind besonders Siliciumdioxid (SiO₂) oder Aluminiumoxid (Al₂O₃) geeignet.

Bei Ausrüstung eines Solarkollektors mit einem erfindungsgemäßen Thermogenerator ist dieser zwischen der Wärme zuführenden Seite und der Wärme abführenden Seite des Absorbers angeordnet.

Die erfindungsgemäßen thermoelektrischen Elemente können außer zur Stromerzeugung auch zur Erzeugung von Kälte oder Wärmeenergie eingesetzt werden, in analoger Weise wie dies von Peltierelementen bekannt ist.

Die Erfindung soll nachstehend an einem Beispiel erläutert werden.

In der zugehörigen Zeichnung zeigen:
- Fig. 1: die Anordnung des erfindungsgemäßen Thermogenerators Innerhalb eines Solarkollektors, als Längsschnitt, und
- Fig. 2: den schematischen Aufbau der Funktionsschicht als Schnitt gemäß der Linie A-A In Fig.1.

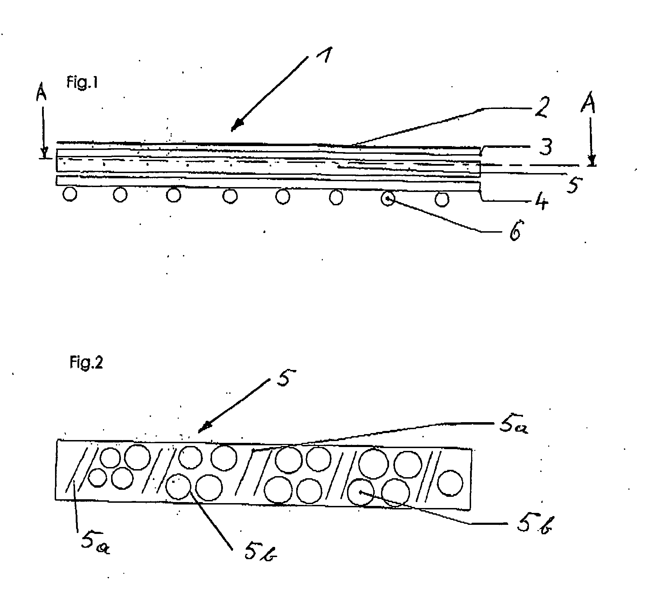

Der in Fig. 1 gezeigt Solarkollektor 1 ist nur vereinfacht dargestellt, ohne Rahmen, Abdeckung und Bodenplatte. Unmittelbar unterhalb der Absorberschicht 2, der über die auf die Abdeckung des Kollektors auftreffende Sonnenstrahlung Wärme zugeführt wird, sind parallel beabstandet, die flächenförmigen Halbleiterelemente 3 und 4 angeordnet, an die die nicht näher gezeigten Ausgänge für den erzeugten Strom angeschlossen sind. Zwischen den beiden Elementen 3 und 4 Ist die Funktionsschicht 5 angeordnet. Das untere Halbleiterelement 4 liegt auf der das Wärmeträgermedium führenden Rohrschlange 6 auf. Zwischen den beiden Halbleiterelementen 3 und 4 besteht Im Betriebsfall (Sommerzeit) ein Temperaturunterschied von ca. 100 bis 200 °C.

Die in Fig. 2 gezeigte Funktionsschicht 5 besteht aus alternierend angeordneten Abschnitten 5a aus Kohlenstoff-Nano-Röhrchen-Material und Isoliermaterial 5b aus Siliciumdioxid. Die Kohlenstoff-Nano-Röhrchen 5a sind entweder im rechten Winkel zu den Halbleiterelementen 3 und 4 oder In einem leicht geneigten Winkel, wie z.B. von 10°, angeordnet. Die Kohlenstoff-Nano-Röhrchen stehen mit ihren beiden Stirnseiten in Berührungskontakt mit den Innenseiten der beiden flächenförmigen Halbleiterelemente 3 und 4.

Aufgrund der unterschiedlichen Temperaturen zwischen den beiden Halbleiterelementen 3 und 4 entsteht zwischen diesen eine Thermospannung und im Leiterstromkreis fließt ein Thermostrom. Die Elektronen können nahezu ohne Widerstand von dem oberen Halbleiterelement 3 über die die Kohlenstoff-Nano-Röhrchen 5a zu dem unteren Halbleiterelement 4 fließen. An der Außenseite der Kohlenstoff-Nano-Röhrchen wird ein Magnetfeld erzeugt, das die Konzentration den Elektronenstroms begünstigt. Aufgrund der hohen Strom leitfähigkeit der Kohlenstoff-Nano-Röhrchen kommt es während des Fließens der Elektronen zu einem sogenannten Tunneleffekt. Die Wärme reflektierende Isolationsschicht wirkt wie ein Temperaturschild. Die sehr gute elektrische Leitfähigkeit der Kohtenatoff-Nano-Röhrehen führt zu einer optimalen Wärmerückstrahlung, wobei der Wärmefluss im Wesentlichen über den Elektronenstrom erfolgt. Eine zwischen den Halbleiterelementen anliegende hohe Temperaturdifferenz kann somit problemlos gehalten werden. Diese Effekte führen zu einer wesentlichen Erhöhung des Wirkungsgrades der thermoelektrischen Elemente.

## Patentansprüche

1. Thermoelektrisches Element, insbesondere zur Erzeugung elektrischer Energie, bestehend aus zwei unterschiedlichen Metallen oder Halbleitern, die mit unterschiedliche Temperaturen aufweisenden Medien in Verbindung stehen, **dadurch gekennzeichnet, dass** zwischen den Elementen (3, 4) aus Metall oder Halbleitern eine Funktionsschicht (5) aus zwei Komponenten (5a, 5b) als Matrix angeordnet ist, wobei die erste Komponente (5b) aus einem Wärme reflektierenden Isolationsmaterial besteht und die zweite Komponente (5a) aus einem Material auf Basis Kohlenstoff-Nano-Röhrchen oder einem Vorprodukt aus der Herstellung von Kohlenstoff-Nano-Röhrchen als mehratomige Kohlenstoff-Halbkugeistruktur, und beide Komponenten (5a, 5b) In unmittelbarem Kontakt mit beiden Metallen oder Halbleitern stehen.

2. Thermoelektrisches Element nach Anspruch 1, **dadurch gekennzeichnet, dass** die beiden Komponenten (5a, 5b) der Funktionsschicht (5) alternierend angeordnet sind.

3. Thermoelektrisches Element nach einem der Ansprüche 1 oder 2, **dadurch gekennzeichnet, dass** die Elemente (3, 4) aus Metall oder Halbleiter als flächenförmig ausgebildet und In einem parallelen Abstand von 1 bis 1000 Nanometer angeordnet sind.

4. Thermoelektrisches Element nach einem der Ansprüche 1 bis 3, **dadurch gekennzeichnet, dass** die Kohlenstoff-Nano-Röhrchen (5a) einen nahezu einheitlichen Durchmesser im Bereich von 1 bis 100 Nanometer besitzen.

5. Thermoelektrisches Element nach einem der Ansprüche 1 bis 4, **dadurch gekennzeichnet, dass** die Kohlenstoff-Nano-Röhrchen (5a) unterschiedliche Durchmesser aufweisen.

6. Thermoelektrisches Element nach einem der Ansprüche 1 bis 5, **dadurch gekennzeichnet, dass** die Kohlenstoff-Nano-Röhrehen (5a) in einem rechten Winkel oder in einem leicht geneigten Winkel von bis zu 10° zu den Elementen (3, 4) aus Metall oder Halbleitern angeordnet sind.

7. Thermoelektrisches Element nach einem der Ansprüche 1 bis 6, **dadurch gekennzeichnet, dass** das Isolationsmaterial (5b) aus Siliciumdioxid (SiO₂) oder Aluminiumoxid (Al₂O₃) besteht.

8. Thermoelektrisches Element nach einem der Ansprüche 1 bis 7, **dadurch gekennzeichnet, dass** dieses in einem Solarkollektor (1) zwischen der Wärme zuführenden Seite (2) und der Wärme abführenden Seite (6) des Absorbers angeordnet ist.
